# EUROPEAN PATENT APPLICATION

(11) **EP 2 557 476 A1**
(43) Date of publication of application: **13.02.2013**
(21) Application number: 12179684.1
(22) Date of filing: 08.08.2012
(51) Int. Cl.: G06F 1/16, G06F 3/044

(54) **Micro structure substrates for sensor panels**

(30) Priority: 12.08.2011 US 201161522982 P; 27.06.2012 US 201213535008; 02.08.2012 US 201213565015
(71) Applicant: Chen, Shi-Chiung, Taoyuan County 333 (TW)
(72) Inventor: Chen, Shi-Chiung, Taoyuan County 333 (TW)
(74) Representative: Grünecker, Kinkeldey, Stockmair & Schwanhäusser

(57) **Abstract**

A sensor panel comprises a flexible film of a thickness having a first surface and a second surface spaced apart from the first surface by the thickness of the film; an array of micro structures in the flexible film, each micro structure including a chamber formed into the flexible film from the first surface; and an array of sensors on the second surface for generating current induced by static electric charge.

## Description

### BACKGROUND OF THE INVENTION

The present invention generally relates to micro fabrication and, more particularly, to substrates with micro structures for flexible sensor panels and bendable flexible sensor panels.

With all kinds of electronic products becoming more compact, miniaturized, and light-weighted, consumers often face the dilemma of, for example, choosing between a light and compact cellular phone, notebook computer or touch panel device, which generally has a small screen, and a heavier and bulkier counterpart, which, nevertheless, has a larger screen. Having an external sensor panel connected to a compact size device is often a compromise which some consumers have come to. However, sensor panels are generally formed on rigid substrates such as glasses or wafers, which are heavy and inconvenient to carry around. Some lighter and thinner sensor panels are provided on polymers, and have a small degree of flexibility. Generally, such flexible sensor panels can be rolled up by less than one turn.

It is desirable to provide thin and light-weight sensor panels with flexibility to the degree where the sensor panels can be rolled up by at least one turn, and preferably two or more turns.

### BRIEF SUMMARY OF THE INVENTION

One example consistent with the invention may provide a sensor panel comprises a flexible film of a thickness having a first surface and a second surface spaced apart from the first surface by the thickness of the film; an array of micro structures in the flexible film, each micro structure including a chamber formed into the flexible film from the first surface; and an array of sensors on the second surface for generating current induced by static electric charge.

Other objects, advantages and novel features of the present invention will be drawn from the following detailed examples of the present invention with attached drawings.

### BRIEF DESCRIPTION OF THE SEVERAL VIEWS OF THE DRAWINGS

The foregoing summary as well as the following detailed description of the preferred examples of the present invention will be better understood when read in conjunction with the appended drawings. It is understood, however, that the invention is not limited to the precise arrangements and instrumentalities shown. Furthermore, it will be appreciated that for simplicity and clarity of illustration, elements shown in the figures have not necessarily been drawn to scale. For example, the dimensions of some of the elements may be exaggerated relative to the others, for the sake of clarity. In the drawings:

FIG. 1 is a three-dimensional (3D) diagram illustrating a substrate for a flexible display device in accordance with an example of the present invention;

FIGs. 2A and 2B are schematic diagrams illustrating a top view and a cross sectional view of a flexible film with an array of micro structures in accordance with another example of the present invention;

FIG. 3 is a schematic diagram illustrating a cross section of a pair of micro-punching molds;

FIG. 4 is a flow diagram illustrating a method for forming a substrate for a flexible display device in accordance with an example of the present invention;

FIG. 5 is a schematic diagram illustrating a cross sectional view of a substrate for a bendable flexible display device in accordance with an example of the present invention;

FIG. 6 is a schematic diagram illustrating a cross sectional view of a substrate for a bendable flexible display device in accordance with another example of the present invention;

FIG. 7 is a schematic diagram illustrating a cross sectional view of a substrate for a flexible display device in accordance with another example of the present invention; and

FIG. 8 is a schematic diagram illustrating a cross sectional view of a substrate for a bendable flexible touch screen display device in accordance with an example of the present invention.

### DETAILED DESCRIPTION OF THE INVENTION

Reference will now be made in detail to the present examples of the invention illustrated in the accompanying drawings. Wherever possible, the same reference numbers will be used throughout the drawings to refer to the same or like portions.

The present invention utilizes a micro-fabrication technology to form flexible films with micro structures. Specifically, micro-fabrication technology is employed to form micro structures in a thin and flexible polymer film, which may be a component of a substrate for a flexible display device, which may be rolled up by one turn (360°), or a bendable flexible display device, which may be rolled up by at least two turns (720°).

A first type of micro structure in a film according to an example of the present invention refers to a structure with an opening punched into the film from a first surface of the film, but does not punch through the film, and does not form significant protrusions on the surface opposite the first surface. Moreover, the micro structure may have a diameter ranging from approximately 100 micrometers (µm) to 500 µm.

A second type of micro structure in a film according to an example of the present invention refers to a structure with an opening punched into the film, and forms a protrusion on the surface opposite the first surface. The height of the protrusion is approximately the same or less than the depth of the micro structure.

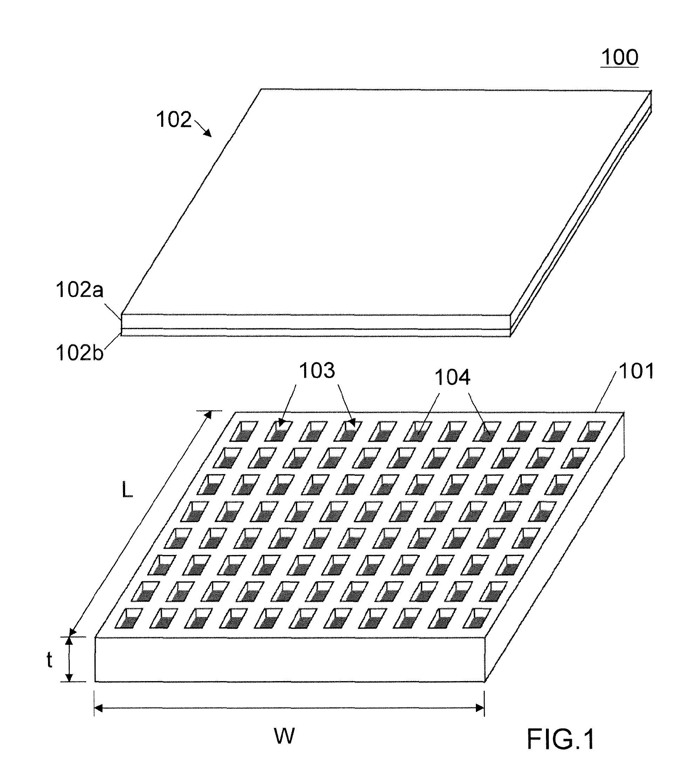

FIG. 1 is a 3D diagram illustrating a substrate 100 for a flexible display device. The substrate 100 comprises a flexible film 101 and an adhesive film 102.

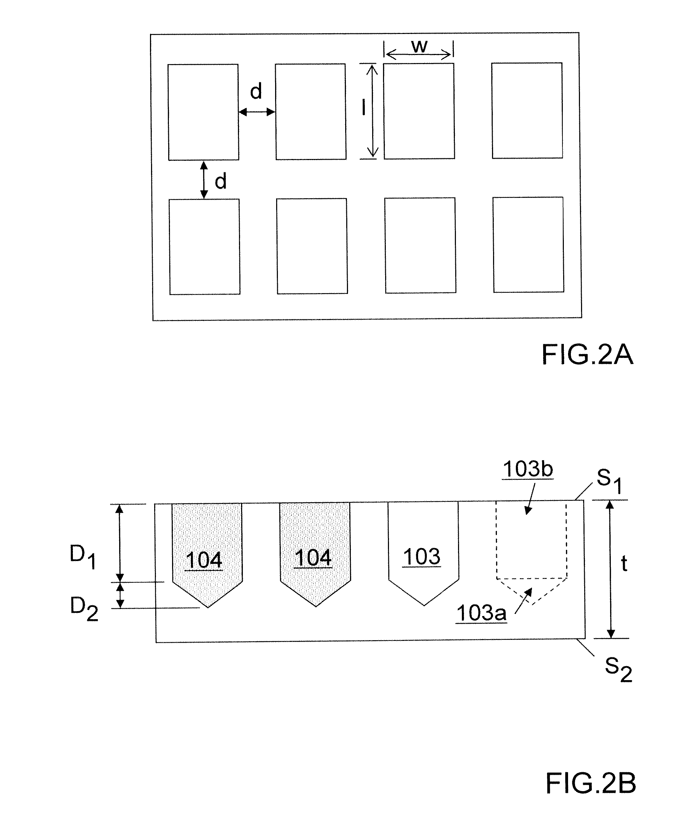

The flexible film 101 has a thickness t, which may range from 97.5 to 102.5 µm. The flexible film 101 has a first surface S₁ and a second surface S₂ (as shown in FIG. 2B) spaced apart by the thickness t of the flexible film 101. The substrate 100 further comprises an array of micro structures 103 in the flexible film 101. The size of the flexible film 101 and the number of micro structures 103 may vary and be customized based on the application of the film. According to an example of the present invention, the size of the flexible film 101 may be one of A4, A3 and A2 paper sizes, which measure 297 by 210 mm (millimeter), 420 by 297 mm and 594 by 420 mm, respectively, in length L and width W.

The chamber of each micro structure 103 is filled with powder 104 that is attractive to electrostatic force and exhibits different colors in response to different voltage levels. For example, the powder 104 may be liquid crystal powder, which can be obtained from Merck & Co., Inc. Each of the micro structures 103 with powder 104 filled therein may serve as a pixel for the flexible display device.

FIGs. 2A and 2B illustrate a top view and a cross sectional view of the flexible film 101, respectively. Each micro structure 103 includes a chamber formed into the flexible film 101 from the first surface S₁, where the chamber has a concave portion 103a with a predetermined depth D₂ near the second surface S₂, and has a sidewall portion 103b near the first surface S₁. The sidewall portion 103b has a predetermined depth D₁ from the first surface S₁.

The depth D₁ of the sidewall portion 103b is between 5 to 75 µm. For example, the depth D₁ of the sidewall portion 103b is determined based on the desired visible range. In an example, the depth D₁ of the sidewall portion 103b is incremented by 5 µm for every two-meter (2 m) increment in the visible range. For instance, for a visible range of 2 m, the depth D₁ of the sidewall portion 103b may be approximately 5 µm, while for a visible range of 20 m, the depth D₁ of the sidewall portion 103b may be approximately 50 µm. In addition, the depth D₁ of the sidewall portion 103b may be determined based on the desired resolution and brightness of the display device.

In accordance with an example of the present invention, the depth D₁ of the sidewall portion 103b may be approximately 5 µm. Because the amount of powder 104 in the device is little, the resulting brightness is suitable for use in small spaces, such as a room in a house.

In accordance with another example of the present invention, the depth D₁ of the sidewall portion 103b may be approximately 15 µm. A display device of such contains a larger amount of powder 104, resulting in brightness that is suitable for use in slightly larger spaces, such as an office space.

In accordance with yet another example of the present invention, the depth D₁ of the sidewall portion 103b may be approximately 40 µm. A display device comprising such substrate will have brightness suitable for use in larger closed space, such as an auditorium.

In accordance with an example of the present invention, the depth D₁ of the sidewall portion 103b may be approximately 75 µm. Since it will contain a large amount of powder 104 in each micro structure 103, the resulting brightness will be suitable for use in display devices that are used outdoor.

The depth D₂ of the concave portion 103a may be determined based on the depth D₁ of the sidewall portion 103b, and the rate at which the concave portion 103a tapers toward the second surface S₂ may be determined based on the dimension of the sidewall portion 103b.

The cross section of the sidewall portion 103b parallel to the first surface S₁ may be one of a circular, elliptical and polygon shape. The cross section may be uniform throughout the sidewall portion 103b. An example of the micro structure 103 according to the present invention has a sidewall portion 103b which has a rectangular cross section. The length 1 and width w of the rectangular cross section are 90µm and 70µm, respectively. Each micro structure 103 is separated by a predetermined distance d. The predetermined distance may be approximately 15µm.

The concave portion 103a, on the other hand, may have a circular, elliptical or polygonal cross section parallel to the first surface S₁, which tapers towards the second surface S₂. The cross section of the concave portion 103a perpendicular to the first surface S₁ may be one of an equilateral triangle, an isosceles triangle, a parabola, and a semi-circle.

In an example in accordance with the present invention where the cross section of the concave portion 103a perpendicular to the first surface S₁ is an isosceles triangle, the two equal angles of the isosceles triangle are 45 degrees.

The flexible film 101 comprises a polymer which provides the flexible film 101 a 90% or greater transparency. For example, the polymer may be one of polyethylene terephthalate (PET), polycarbonate (PC) and optical polyethylene naphthalate (OPEN).

The repeating chemical structure unit of OPEN is the following formula:

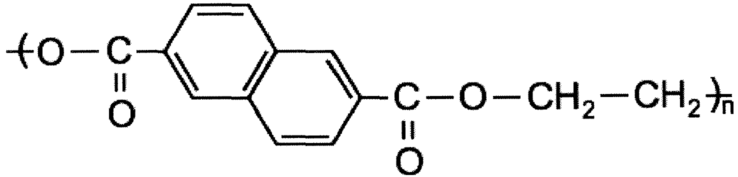

The density of the flexible film 101 is between 0.86 and 0.98 gram per cubic centimeter (g/cm³). Other physical properties of the flexible film 101 may include: the tensile strength is between 234 and 246 megapascal (MPa), the tensile modulus is between 4.55 to 5.04 gigapascal (GPa), and the tearing strength is between 697 and 899 millinewton (mN).

The concave portion 103a provides greater and denser luminance at the center of each micro structure, since it has the highest concentration of liquid crystal powder 104 at the center.

The adhesive film 102 comprises a polymer layer 102a with a conductive pattern (not shown) embedded therein, and an adhesive 102b attached to the polymer layer 102a. The polymer layer 102a may comprise one of PET, PC and OPEN, and the conductive pattern may comprise copper. The thickness of the conductive pattern is approximately one milli-inch, which is equivalent to approximately 25.4 µm. The adhesive 102b may comprise water glue, such as acrylic-base glue, and has a thickness between 10 to 15 µm.

According to the present invention, each of the micro structures 103 with powder 104 filled therein may serve as a pixel for the flexible display device. Furthermore, the conductive pattern on the polymer layer 102a functions to electrically address the micro structures 103.

The substrate 100 according to the present invention provides the means to manufacture a display device that is highly flexible. For example, a flexible display device manufactured with the substrate 100 may be rolled up by one turn (360°). In another example in accordance with the present invention, a bendable flexible display device may be rolled up by at least two turns (720°).

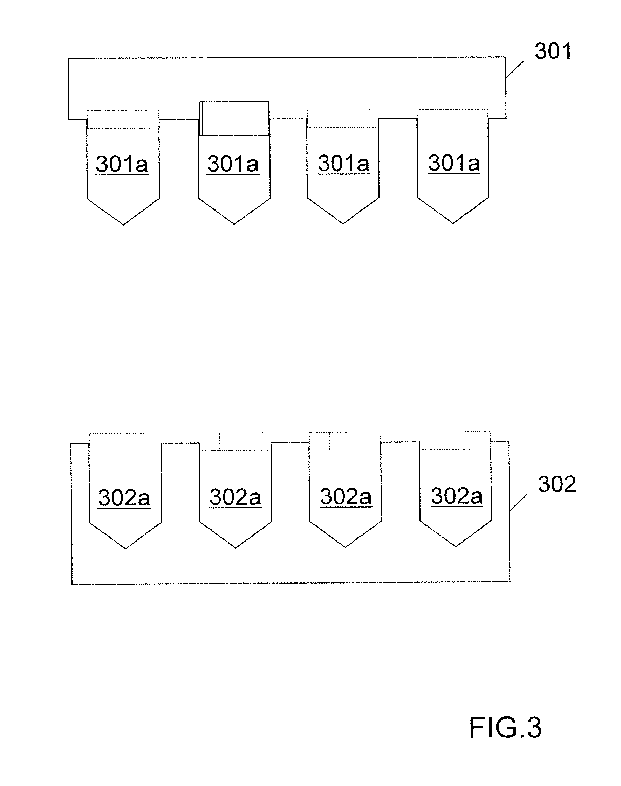

FIG. 3 is a schematic diagram illustrating a cross section of a pair of micro-punching molds 301, 302 for fabricating the micro structures 103 in the flexible film 101.

The pair of micro-punching molds 301, 302 comprises an upper mold 301 and a lower mold 302. The upper mold 301 comprises a plurality of protrusions 301a, and the lower mold 302 comprises a plurality of micro structures 302a which correspond to the plurality of protrusions 301a of the upper mold 301. The size of the molds 301, 302 and the number of protrusions 301 a and micro structures 302a may vary and be customized based on the application of the film.

According to an example of the present invention, the size of the molds 301, 302 may be one of A4, A3 and A2 paper sizes, which measure 297 by 210 mm, 420 by 297 mm and 594 by 420 mm, respectively. According to an example of the present invention, each micro structures 302a of the lower mold 302 has the same structure as the structure of the plurality of micro structures 103 of the flexible film 101 described above.

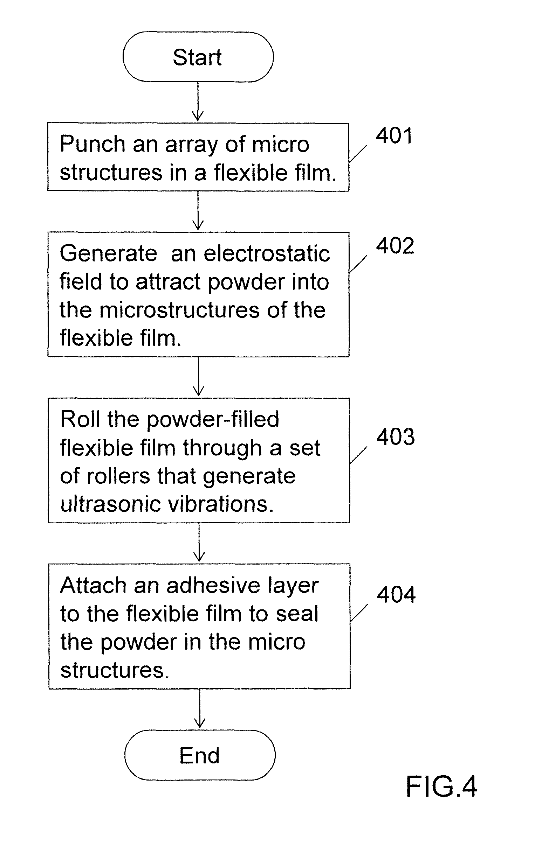

A method for manufacturing the substrate 100 according to an example of the present invention will now be described with reference to FIG. 4.

First, a roll of flexible film comprising one of PET, PC and OPEN is unrolled and placed between the pair of micro-punching molds 301, 302. The roll of flexible film has a density between 0.75 to 0.85 g/cm³. In step 401, the flexible film is punched by the pair of micro-punching molds 301, 302 by a "kiss-touch" method. Specifically, the force which the upper mold 301 punches the flexible film 101 is controlled so that the upper mold 301 does not punch through the flexible film 101 but punches a plurality of micro structures 103 with the desired depth. Moreover, to facilitate the punch process, an array of such upper molds 301 and a corresponding array of such lower molds 302 may be employed, with an array dimension sized to fit the film dimension.

In step 402, after the plurality of micro structures 103 were punched, the thin film is flipped over, so the openings of the micro structures 103 face downward over a tray filled with powder for filling the chambers of the micro structures 103. Subsequently, when a means for generating electrostatic field is turned on, the powder 104 in the tray is attracted upward by an electrostatic force and fills the chamber of each micro structure 103.

Some powder will be attracted to the surface between the micro structures 103, which is removed by rolling the powder-filled flexible film through a set of rollers that generates ultrasonic vibration in step 403. The excess powders that are stuck on the surface between the micro structures are shaken off by the ultrasonic vibration.

Next, in step 404, an adhesive film 102 having a conductive pattern is attached to the powder-filled flexible film 101, thereby forming the substrate 100. The substrate 100 may be rolled through a set of rollers, so as to press the adhesive film 102 and the flexible film 101 together properly and ensure the flexibility of the substrate 100.

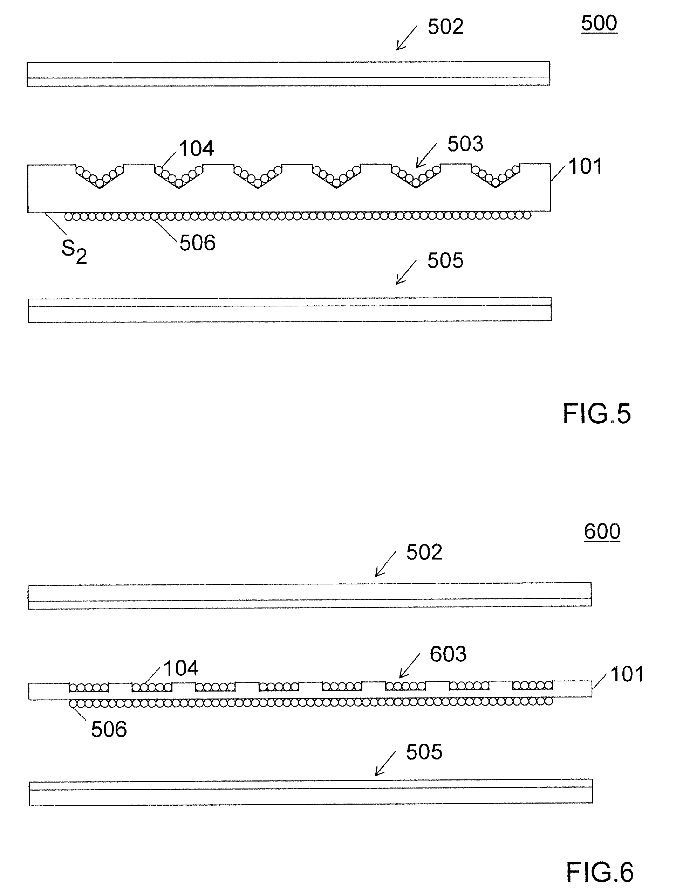

FIG. 5 is a schematic diagram illustrating a cross sectional view of a substrate 500 for a bendable flexible display device, which may be rolled up by at least two turns (720°), in accordance with an example of the present invention. The substrate 500 comprises a thin film 101, a first adhesive layer 502, and a second adhesive layer 505. The substrate 500 further comprises an array of micro structures 503 of the first type in the thin film 101, and each micro structure 503 comprises a layer of powder 104 on the bottom surface.

The first adhesive film 502 and the second adhesive film 505 illustrated in FIG. 5 are similar to the adhesive film 102 illustrated in FIG. 1, except that neither the first adhesive film 502 nor the second adhesive film 505 comprises a conductive pattern for electrically addressing the micro structures 503.

The substrate 500 comprises a layer of silicon powder 506 on the second surface S₂. The layer of silicon powder 506 is adhered to the second surface S₂ by way of electrostatic-adsorption, and is sealed by the second adhesive layer 505.

The layer of silicon powder 506 functions as a solar panel. Photons in sunlight hit the layer of silicon powder 506 and are absorbed by the silicon powder 506. Electrons are knocked loose from their atoms, causing an electric potential difference. Currents start flowing through the silicon powder 506 to cancel the electric potential difference and this electricity is captured.

The bendable flexible display device may comprise solar cells and an integrated circuit (IC) for controlling the collection of the electricity generated, and providing different voltages to the micro structures 503, in order to control the color changes of the powder 104. The IC and the solar cells may be disposed between the thin film 101 and the first adhesive film 502 or the second adhesive film 505. The total thickness of the bendable flexible display device is less than 200 µm.

FIG. 6 is a schematic diagram illustrating a cross sectional view of a substrate 600 for a bendable flexible display device, which may be rolled up by at least two turns (720°), in accordance with another example of the present invention. The substrate 600 illustrated in FIG.6 is similar to the substrate 500 illustrated in FIG. 5 except that the micro structure 603 does not comprise a concave portion. Instead, the micro structure 603 has a flat bottom.

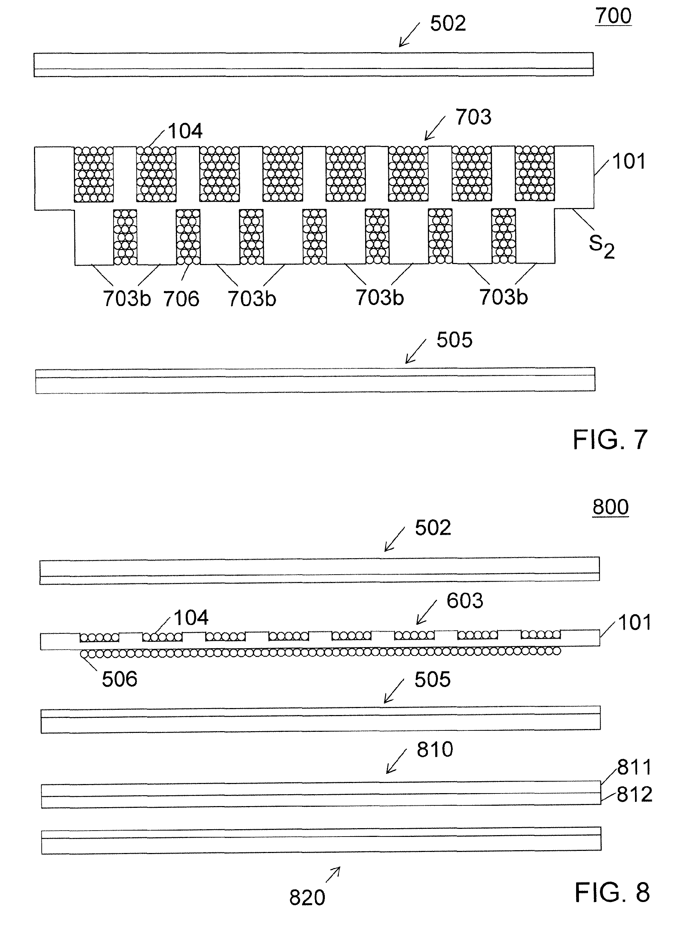

FIG. 7 is a schematic diagram illustrating a cross sectional view of a substrate 700 for a flexible display device in accordance with another example of the present invention. The substrate 700 is similar to the substrate 600 illustrated in FIG. 6, except that the flexible film 101 comprises an array of micro structures 703 of the second type, which comprises protrusions 703b out of the second surface S₂. Furthermore, the micro structures 703 are filled with the powder 104, and the space between the protrusions 703b are filled with crystalline silicon 706 for generating electricity from solar energy.

The present invention further relates to substrates with micro structures for flexible sensor panels, which may be rolled up by one turn (360°), or bendable flexible sensor panels, which may be rolled up by at least two turns (720°). A flexible sensor panel or a bendable flexible sensor panel in accordance with an example of the present invention may comprise one of the substrates illustrated in FIGs. 1, 5, 6 and 7, and further comprise an array of sensors configured generate current induced by static electric charge.

FIG. 8 is a schematic diagram illustrating a cross sectional view of a substrate 800 for a bendable flexible sensor panel in accordance with an example of the present invention. The substrate 800 in FIG. 8 comprises the substrate 600 for a bendable flexible display device illustrated in FIG. 6, an array of sensors 810, and a third adhesive film 820. The array of sensors 810 comprises a patterned isolation layer 811 and a patterned conductive gel layer 812. The patterned isolation layer 811 may include silicon oxide or other insulating materials, and have a thickness between 25 to 50 µm. The patterned conductive gel layer 812, and have a thickness between 2.5 to 10 µm.

The patterned isolation layer 811 and the patterned conductive gel layer 812 are formed such that when an object that carries static electric charge, such as a finger or a stylus, is in close proximity to the sensor panel, the static electric charge from the object may induce current flowing through at least one of the array of sensors 810 under the object. An IC connected to the array of sensors 810 may detect the induced current and determine the origin of the induced current on the sensor panel, i.e., the position of the object with respect to the sensor panel.

The density of the microstructures 503 in the flexible film 101 may be between 160 to 280 micro structures per square inch. In accordance with an example of the present invention, the flexible film 101 comprises 200 micro structures per square inch. The stylus may include a tip comprising carbon. In accordance with the present invention, the finger or stylus does not need to be in physical contact with the sensor panel in order to induce current. The sensor panel is sensitive to a "touch" when the finger or stylus is at a distance between 1 to 1.5 mm from the surface of the sensor panel.

In describing representative examples of the present invention, the specification may have presented the method and/or process of operating the present invention as a particular sequence of steps. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the specification should not be construed as limitations on the claims. In addition, the claims directed to the method and/or process of the present invention should not be limited to the performance of their steps in the order written, and one skilled in the art can readily appreciate that the sequences may be varied and still remain within the spirit and scope of the present invention.

It will be appreciated by those skilled in the art that changes could be made to the examples described above without departing from the broad inventive concept thereof. It is understood, therefore, that this invention is not limited to the particular examples disclosed, but it is intended to cover modifications within the spirit and scope of the present invention as defined by the appended claims.

## Claims

1. A sensor panel comprising:
a flexible film of a thickness having a first surface and a second surface spaced apart from the first surface by the thickness of the film;
an array of micro structures in the flexible film, each micro structure including a chamber formed into the flexible film from the first surface; and
an array of sensors on the second surface for generating current induced by static electric charge.

2. The sensor panel of claim 1, wherein the array of sensors comprises a patterned isolation layer on the second surface and a patterned conductive gel layer on the patterned isolation layer.

3. The sensor panel of claim 2, wherein the patterned isolation layer comprises silicon oxide.

4. The sensor panel of claim 1, wherein the flexible film comprises 160-280 micro structures per square inch.

5. The sensor panel of claim 1 further comprising an integrated circuit connected to the array of sensors for detecting the induced current and determining the origin of the induced current on the sensor panel.

6. The sensor panel of claim 1 further comprising a layer of silicon powder adhered to the second surface.

7. The sensor panel of claim 6 further comprising a first adhesive layer between the layer of silicon powder and the array of sensors, the first adhesive layers includes a polymeric core comprising one of polyethylene terephthalate (PET), polycarbonate (PC) and optical polyethylene naphthalate (OPEN).

8. The sensor panel of claim 1 further comprises a plurality of protrusions on the second surface, and crystalline silicon between the plurality of protrusions.

9. The sensor panel of claim 8 further comprising a first adhesive layer between the flexible film and the array of sensors, the first adhesive layers includes a polymeric core comprising one of PET, PC and OPEN.

10. The sensor panel of claim 1, wherein the chamber has a concave portion near the second surface.

11. The sensor panel of claim 10, wherein the concave portion has one of a circular, elliptical and a polygonal cross section tapering towards the second surface.

12. The sensor panel of claim 1, wherein the chamber has a sidewall portion near the first surface, the sidewall portion has a depth of 5N micrometers (µm) from the first surface, N being a natural number from 1 to 15, and wherein the sidewall portion includes one of a circular, elliptical and a polygonal cross section.

13. The sensor panel of claim 12, wherein the cross section of the sidewall portion is a 90 by 70 µm rectangle, and the distance between each rectangle is 15 µm.

14. The sensor panel of claim 1, wherein each micro structure includes powder that is attractive to an electrostatic force and exhibits different colors in response to different voltages in the chamber of the micro structure.

15. The sensor panel of claim 14, wherein the powder includes liquid crystal powder.

16. The sensor panel of claim 1, wherein the flexible film comprises a polymer which provides the film a 90% or greater transparency.

17. The sensor panel of claim 16, wherein the flexible film includes a polymeric core comprising one of PET, PC and OPEN, and the polymer of the flexible film is one of PET, PC and OPEN.

18. The sensor panel of claim 1 wherein the density of the flexible film is between 0.86 to 0.98 g/cm³, the tensile strength of the flexible film is between 234 and 246 MPa, the tensile elongation of the flexible film is between 126 and 173%, the tensile modulus of the flexible film is between 4.55 to 5.04 GPa, the tearing strength of the flexible film is between 697 and 899 mN, and the thickness of the flexible film is between 97.5 and 102.5 micrometer.

19. The sensor panel of claim 1 further comprises a second adhesive layer on the first surface, and a third adhesive layer on the array of sensors, the second and third adhesive layers include a polymeric core comprising one of PET, PC and OPEN.
